(19) Europäisches Patentamt

European Patent Office

Office européen des brevets

(11) **EP 1 503 181 A1**

(12) **EUROPÄISCHE PATENTANMELDUNG**

(43) Veröffentlichungstag:
02.02.2005 Patentblatt 2005/05

(51) Int Cl.⁷: **G01D 5/14**, G01D 3/036

(21) Anmeldenummer: 03102381.5

(22) Anmeldetag: 31.07.2003

(84) Benannte Vertragsstaaten:
**AT BE BG CH CY CZ DE DK EE ES FI FR GB GR HU IE IT LI LU MC NL PT RO SE SI SK TR**
Benannte Erstreckungsstaaten:
**AL LT LV MK**

(71) Anmelder: **Getrag Ford Transmissions GmbH**
**50735 Köln (DE)**

(72) Erfinder: **Kather, Lutz**
**52146, Würselen (DE)**

(74) Vertreter: **Drömer, Hans-Carsten, Dr.-Ing. et al**
**Ford-Werke Aktiengesellschaft,**
**Patentabteilung NH/DRP,**
**Henry-Ford-Strasse 1**
**50725 Köln (DE)**

(54) **Verfahren zur Positionserfassung und Positionsmesssystem**

(57) Die Erfindung bezieht sich auf ein Verfahren zur Positionserfassung mittels magnetischer Positonssensoren, bei dem durch eine Auswertung der Eintauchtiefen die Position ermittelt wird, wobei die Auswertung der Eintauchtiefe unter Verwendung von die Position eines in einer Richtung verschiebbaren, mit der zu erfassenden Position gekoppelten Magneten 12 erfassenden, Sensorelementen 11 erfolgt, wobei der mit der zur erfassenden Position gekoppelte verschiebbare Magnet 12 in den Magnetkreis eingreift und die Feldstärke an den die Position des Magneten 12 erfassenden Sensorelementen 11 geeignet beeinflußt und wobei der Einfluß von Fremdmagnetfeldern 14 an den Sensorelementen 11 weitestgehend kompensiert wird. Es ist dabei erfindungsgemäß vorgesehen, daß die Kompensation des Einflusses von Fremdmagnetfeldern 14 an den Sensorelementen 11 durch eine aktive Kompensation der Fremdmagnetfelder 14 über eine Verwendung wenigstens eines weiteren, die Fremdmagnetfelder 14 in einer separaten Messung erfassenden, Sensorelementes 15 erfolgt. Die Erfindung bezieht sich außerdem auf ein entsprechendes Positionsmeßsystem 10.

Fig.2

**Beschreibung**

Die Erfindung bezieht sich auf ein Verfahren zur Positionserfassung mittels magnetischer Positionssensoren gemäß Anspruch 1 und auf ein Positionsmeßsystem gemäß Anspruch 9.

Aus dem Stand der Technik sind verschiedene Verfahren und Vorrichtungen zur Erfassung der Position eines Rastelementes, beispielsweise eines Positionsensors eines Wählmechanismus für die verschiedenen Gangstufen eines Fahrzeuggetriebes, bekannt. Das Rastelement arretiert dabei auf einer Scheibe signifikante Positionen eines Wählmechanismus, welche den verschiedenen Gangstufen eines Fahrzeuggetriebes entsprechen. Die Scheibe ist dabei so ausgeführt, daß die Arretierungsmulden unterschiedliche Tiefen aufweisen, wodurch sich unterschiedlich hohe Plateaus auf der Scheibe ergeben. Durch eine Auswertung der Eintauchtiefe des Rastelementes läßt sich auf die jeweilige Stellung der Wahlscheibe schließen.

Für die Auswertung der Eintauchtiefe können aus technischer Sicht alle bekannten Wegmeßverfahren eingesetzt werden. Aus Kostengesichtspunkten sind die auf dem Hallprinzip basierenden Sensortechnologien hier von besonderem Interesse. Der Einbauort im Motorraum direkt am Fahrzeuggetriebe ist in diesem Anwendungsfall besonders starken EMV Störungen ausgesetzt, insbesondere starken magnetischen Wechselfeldern aufgrund stromführender Leitungen, sowie sehr großen Temperaturschwankungen von bis zu 200K. Die daraus resultierenden Fehler sind keine konstanten Größen, die durch einen Einlernprozeß kompensiert werden können.

Die bekannten Meßverfahren zur Positions-Bestimmung mit Hallsensoren benutzen meistens das Prinzip der Feldschwächung/ -verstärkung mittels eines mit der zu erfassenden Position gekoppelten Elementes, welches in den Magnetkreis eingreift und die Feldstärke an der Position des Hallsensors in geeigneter Weise beeinflußt. Der Nachteil dieses Verfahrens ist, daß weitere Magnetfelder, verursacht durch stromdurchflossene Leiter etc. diesem magnetischen Feld überlagert werden und das Meßergebnis verfälschen. Übliche Abhilfemaßnahmen sind Abschirmungen aus hochpermeablen Material.

Ein weiterer Nachteil ist die aufwendige Temperaturkompensation der nichtlinearen Funktion der Temperaturabhängigkeit von Hallgeneratoren, die den wesentlichen Bestandteil der Hallsensoren bilden.

Aus dem Stand der Technik ist dazu z.B. aus der EP 1 059 506 A2 ein Wegaufnehmer bekannt, hier vorgesehen für die Regelung eines Ventiles in einem Abgasrückführungssystem einer Verbrennungskraftmaschine, mit einem PermanentMagneten, der in einem Primärluftspalt zwischen ferromagnetischen Flußleitstücken linear verschieblich ist und mit einem Magnetfeldsensor, der in einem Arbeitsluftspalt zwischen den Flußleitstücken angeordnet ist. Zum Eliminieren des Einflusses von Fremdmagnetfeldern in axialer Richtung sind der Magnetfeldsensor und der Arbeitsluftspalt so angeordnet, daß die Meßempfindlichkeitsrichtung des Magnetfeldsensors senkrecht zur Verschieberichtung des Magneten steht. Es ist dabei gemäß einer Ausführungsform vorgesehen, die wirksame Fläche des Arbeitsluftspaltes kleiner als die wirksame Fläche des Primärluftspaltes ist. Weiterhin ist vorgesehen, daß zwei Paare von Flußleitstücken in Verschieberichtung des Magneten hintereinander angeordnet sind und durch einen Koppelspalt voneinander getrennt sind, weiterhin vorgesehen ist, daß in jedem Arbeitsluftspalt beider Paare von Flußleitstücken je eine Hallsonde angeordnet ist.

Bei der dieser Druckschrift zugrunde liegenden Problemstellung wurde davon ausgegangen, daß bei der Anwendung von Schiebewegaufnahmen mit Halleffekt-Sensoren zu beachten ist, daß der störende Einfluß von fremden Magnetfeldern vermieden werden soll, um das Meßergebnis nicht zu verfälschen. Eine Möglichkeit dafür waren z.B. geeignete Abschirmmaßnahmen. Wenn der Wegaufnehmer jedoch mit einem elektromagnetischen Stellglied zu einer kompakten Einheit verbunden werden soll, so sind diese Maßnahmen meist nicht ausreichend oder sehr aufwendig. Ein Beispiel dafür ist, wenn der Wegaufnehmer zusammen mit einem Hubmagneten verwendet wird, ein Beispiel hierfür ist die erwähnte Regelung eines Ventiles in einem Abgasrückführungssystem einer Verbrennungskraftmaschine. Der Hubmagnet kann dabei ein axiales Störfeld erzeugen, welches insb. entlang der Symmetrieachse merkliche Werte annehmen kann. Bei dem oben genannten Wegaufnehmer würde ein solches axiales Störfeld auf den Halleffekt- Sensor einwirken und somit das Meßergebnis unzulässig verfälschen. Durch die hier beschriebene Anordnung soll erreicht werden, daß der Wegaufnehmer weitgehend unempfindlich gegenüber magnetischen Störfeldern ist und zwar insb. gegenüber solchen, die koaxial zur Verschieberichtung wirken. Dazu wird eben der Magnetfeldsensor so angeordnet, daß seine Meßempfindlichkeitsrichtung senkrecht zur Verschieberichtung des Permanent-Magneten steht, wodurch der Einfluß axialer Störmagnetfelder weitgehend eliminiert sein soll. Der Nachteil des in dieser Druckschrift beschriebenen Wegaufnehmers besteht insb. darin, daß die Anwendung sich sehr stark an der dargestellten konstruktiven Ausführung des Wegaufnehmers insb. mit einer Eliminierung von axialen Störmagnetfeldern orientiert, eine Modifizierung bzw. eine Verbesserung ist in diesem Falle wünschenswert.

Weiterhin ist aus der US-A 5 608 317 ein linearer magnetischer Positionssensor bekannt, insb. zur analogen Lageerfassung mit einer Linearisierung und einer Temperaturkompensation. Der lineare magnetische Positionssensor dient dabei zur Erfassung der Position einer Anordnung entlang einer linearen Bewegungsachse, wie es in einer Vielzahl von Anwendungen benötigt wird. Der lineare magnetische Positionssensor umfaßt dabei einen ersten und zweiten magnetischen Sensor, die in einer zueinander beabstandeten Anordnung angeordnet sind, um entsprechende erste und zweite Sensorausgangs- Signale vorzugeben, die die Stärke eines Magnetischen Feldes anzeigen. Der erste und zweite Magnetsensor haben entsprechende erste und zweite sensoraktive Bereiche und sind in einer entgegengesetzten Weise miteinander verbunden, so daß erste und zweite Signale entgegensetzt gepolt werden. Ein längliches Magnetelement ist an der zu bewegenden Anordnung befestigt, der einen einzelnen Magneten umfaßt, der sich über die Ausdehnung eines Bereiches der Bewegunsgstrecke erstreckt, in dem der Sensor eine Position erfassen soll. Dieses Magnetelement ist in einem Winkel in Bezug auf die Bewegungsachse angebracht derart, daß es sich zusammen mit der Anordnung bewegt. Das Magnetelement ist dabei zur Bewegung zwischen dem ersten und zweiten sensoraktiven Bereich angeordnet, so daß, wenn das Magnetelement seine Bewegungslage verändert, wobei sich seine Position in Bezug auf die sensoraktiven Bereiche drehen wird, dadurch die Bewegung des Magnetelementes in eine Änderung des magnetischen Flusses übertragen wird, worauf dann die sensoraktiven Bereiche reagieren. Über wenigstens einen Bereich des Bewegungsbereiches werden die Sensor- Ausgangssignale sich als eine im wesentlichen lineare Funktion der Position des Magnetelementes innerhalb des Bewegungsbereiches verändern. Weiterhin umfaßt der magnetische Positionssensor eine auf das erste und zweite Ausgangssignal reagierende Prozessoreinheit, um die Position der Anordnung entlang der Bewegungsachse zu bestimmen. Die Prozessoreinheit umfaßt dabei einen Arbeitsbereich, der in Abhängigkeit der ersten und zweiten Ausgangssignale Korrekturdaten vorgibt, um Nichtlinearitäten während des Betriebes der Sensorelemente zu korrigieren und die Genauigkeit der Positionsmessung zu verbessern. Dabei ist gemäß einer Ausführungsform vorgesehen, daß der erste und zweite Sensor Halleffekt- Sensoreinrichtungen umfassen. Weiterhin ist vorgesehen, daß der magnetische Positionssensor Mittel zur Temperaturerfassung aufweist, um ein Signal zu erzeugen, das die Umgebungstemperatur charakterisiert, und daß die Prozessoreinheit auf Veranlassung der Temperatursignale hin die Positionsmessung hinsichtlich von Veränderungen während des Betriebes des Systemes aufgrund von Temperaturunterschieden kompensiert. Bei einer abgewandelten Ausführungsform ist außerdem vorgesehen, daß zwei verschiedene Magnetelemente an der bewegbaren Anordnung angebracht sind, um mit den entsprechenden Halleffekt-Sensoreinrichtungen zusammenzuwirken.

Bei der hier beschriebenen Anordnung werden also entgegengesetzt gepolte Spannungssignale der Sensorelemente verstärkt und der Prozessoreinheit zugeführt, wobei über einen Arbeitsbereich dieser Prozessoreinheit Abweichungen von einer Linearität kompensiert werden können. Dabei können Temperaturänderungen ebenfalls gemessen und in den Kompensationsprozeß integriert werden. Bei dieser Anordnung sollen sich bezüglich zuvor bekannter Anordnungen mit magnetisch beaufschlagten Meßsystemen erhebliche Vorteile insb. hinsichtlich des Startzustandes ergeben, nachteilig ist hier allerdings insb., daß der Einfluß von Fremdmagnetfeldern zwischen dem ersten und zweiten sensoraktiven Bereich, in dem sich das oder die Magnetelemente bewegen soll, erheblich sein kann, bzw. daß das Eliminieren dieses Einflusses von Fremdmagnetfeldern nur mit erheblichem Aufwand durch Einsatz bzw. Änderung von speziellen Arbeitsbereichen der Prozessoreinheit erreicht werden kann.

Schließlich ist aus der EP 1 158 275 A1 ein Axialpositionsgeber für eine in axialer Richtung bewegbare Stange und eine elektromagnetische Betätigung für ein mit einem derartigen Axialpositionsgeber versehenes Ventil bekannt. Mit der hier beschriebenen Anordnung soll ein Axialpositionsgeber geschaffen werden, der dazu geeignet ist, präzise die Lage einer Stange zu erfassen, die sich linear mit einer hohen Geschwindigkeit bewegt, weiter soll eine entsprechend ausgebildete Ventilbetätigung für eine Brennkraftmaschine geschaffen werden. Der Axialpositionsgeber für die erwähnte Stange ist dazu in axialer Richtung zwischen zwei bestimmten Positionen hin- und herbewegbar, und umfaßt eine magnetische Hülse mit einer radialen Magnetisierung, die koaxial auf der Stange befestigt ist und die wenigstens auf der Oberfläche magnetisiert ist. Der Axialpositionsgeber umfaßt ferner einen magnetischen Flußsensor, der zwei ferromagnetische Ringe umfaßt, die die magnetische Hülse koaxial in einem Abstand umgeben, und die voneinander in axialer Richtung beabstandet sind. Die beiden Ringe sind mit zwei diametralen Vorsprüngen an einander gegenüberliegenden Seiten versehen, weiterhin sind zwei Hall-Sensoren auf diesen zwei diametralen Vorsprüngen angebracht. Diese Hall-Sensoren sind funktional mit einer Recheneinheit verbunden, um ein Signal bereitzustellen, das einen Differenzwert der Summe des durch die Hall- Sensoren gelangenden magnetischen Flusses anzeigt. Dieser Wert zeigt die axiale Position der erwähnten Stange an. Der Axialpositionsgeber umfaßt ferner den magnetischen Fluß zurückführende Mittel. Es ist dabei bei einer Ausführungsform vorgesehen, daß die Recheneinheit eine integrierte Schaltung umfaßt, die auf einer mit den Hall-Sensoren zusammenwirkenden gedruckten Schaltung angebracht ist. Die Verbindung der Hall- Sensoren mit der gedruckten Schaltung kann dabei auf unterschiedliche, hier nicht näher betrachtete Weisen erfolgen.

Mit der in dieser Druckschrift beschriebenen Anordnung soll insb. ein Axialpositionsgeber geschaffen werden, der die axiale Position der Stange mit einer großen Präzision erfaßt, und zwar insb. für eine Anwendung bei einer elektromagnetischen Betätigung von Ventilen für eine Brennkraftmaschine, wobei die Anordnung hier insb. den Erfordernissen der Praxis gerecht werden soll. Weiterhin soll durch die beschriebene Anordnung eine Reduzierung von Lärm erreicht werden, sowie eine Verbesserung der Mechanik und der Steuerung z.B. der Ventile der Brennkraftmaschine. Nachteilig ist auch bei dieser Anordnung die sehr stark an der dargestellten konstruktiven Ausführung orientierte Anwendbarkeit, die sich insb. durch den Aufbau des magnetischen Flußsensors ergibt. Weiterhin nachteilig sind hier die begrenzten Möglichkeiten zur Kompensation von Fremdmagnetfeldern, eine Modifizierung bzw. Verbesserung ist auch in diesem Fall wünschenswert.

Ausgehend von diesen bekannten Verfahren zur Positonserfassung und Vorrichtungen zur Positionsmessung, beispielsweise eines Positionsensors eines Wählmechanismus für die verschiedenen Gangstufen eines Fahrzeuggetriebes, liegt der Erfindung die Aufgabe zugrunde, die bekannten Verfahren und Vorrichtungen unter Beibehaltung der bisherigen Vorteile in der Weise zu verbessern bzw. weiterzuentwickeln, daß die Nachteile der zuvor diskutierten Lösungen vermieden werden, wobei insbesondere der Einfluß von Fremdmagnetfeldern an den Sensorelementen weitgehend kompensiert werden soll sowie auch der Einfluß von Temperaturschwankungen, und zwar hinsichtlich des Verfahrens auf einfach durchführbare Weise und hinsichtlich der Vorrichtung auf einfach und kostengünstig herstellbare Weise. Es soll dabei auch insb. eine gute Handhabbarkeit im Vordergrund stehen.

Die Aufgabe wird bzgl. des Verfahrens erfindungsgemäß dadurch gelöst, daß die Kompensation des Einflusses von Fremdmagnetfeldern an den Sensorelementen durch eine aktive Kompensation der Fremdmagnetfelder über eine Verwendung wenigstens eines weiteren, die Fremdmagnetfelder in einer separaten Messung erfassenden, Sensorelementes erfolgt. Auf diese Weise wird erstmalig mit einfachen Mitteln die Möglichkeit geschaffen, den Einfluß von Fremdmagnetfeldern an den Sensorelementen weitgehend zu kompensieren sowie auch der Einfluß von Temperaturschwankungen in diesem Bereich, und zwar auf einfach durchführbare Weise. Dabei umfaßt das erfindungsgemäße Verfahren einen Lösungsansatz, bei dem die Störfelder aktiv kompensiert werden. Es wird dazu über das wenigstens eine weitere, die Fremdmagnetfelder in einer separaten Messung erfassende, Sensorelement die von äußeren Einflüssen angeregte Störgröße erfaßt, im Anschluß daran kann beispielsweise über eine Recheneinheit das Signal der Meßposition für die Eintauchtiefe mit Hilfe der Information über die Störgröße korrigiert werden.

Bei der bevorzugten Ausführungsform der vorliegenden Erfindung erfolgt die aktive Kompensation der Fremdmagnetfelder über eine Verwendung wenigstens eines weiteren, die Fremdmagnetfelder in einer separaten Messung erfassenden, auf dem Hallprinzip basierenden Sensorelementes. Diese auf dem Hallprinzip basierenden Sensorelemente sind wie erwähnt insb.

aus Kostengründen in diesem Anwendungsgebiet von besonderem Interesse. Zweckmäßig empfiehlt es sich dabei nach einem weiteren Merkmal der vorliegenden Erfindung, daß die Auswertung der Eintauchtiefe unter Verwendung von auf dem Hallprinzip basierenden, die Position des in einer Richtung verschiebbaren, mit der zu erfassenden Position gekoppelten Magneten erfassenden, Sensorelementen erfolgt.

Nach einem weiteren Ausgestaltungsmerkmal der vorliegenden Erfindung erfolgt die aktive Kompensation der Fremdmagnetfelder über das weitere die Fremdmagnetfelder in einer separaten Messung erfassenden Sensorelement in der Weise, daß die durch die äußeren Einflüsse verursachten magnetischen Felder die Sensorelemente für die Positionsbestimmung und das Sensorelement für die separate Messung der Fremdmagnetfelder in gleicher Weise beeinflussen. In diesem Fall ist der Berechnungsfaktor für die von der Recheneinheit zu ermittelnde Ausgangsgröße besonders vorteilhaft und es ist eine optimale Temperaturkompensation gegeben.

Es empfiehlt sich nach einem weiteren Ausgestaltungsmerkmal der vorliegenden Erfindung, daß die Erfassung des Magnetfeldes über die Sensorelemente für die Positionsbestimmung in der Weise erfolgt, daß sich durch die Gestaltung der Geometrie des Magnetfeldes eine Intensität des Magnetkreises in der erfaßten Richtung ergibt, die ein zur Position des verschiebbaren Magneten proportionales Signal liefert.

Nach einem weiteren Merkmal der vorliegenden Erfindung ist vorgesehen, daß die Messung der magnetischen Felder für die Positionsbestimmung und die separate Messung der Fremdmagnetfelder in geringer räumlicher Entfernung erfolgt. Zweckmäßig erfolgt dabei die Messung der magnetischen Felder für die Positionsbestimmung und die separate Messung der Fremdmagnetfelder über in einem Material mit thermisch hoher Leitfähigkeit eingebettete Sensorelemente. Bei einer derartigen Ausbildung des erfindungsgemäßen Verfahrens ergibt sich für beide Messungen praktisch nahezu der gleiche Temperaturfehler.

Es empfiehlt sich nach einem weiteren Merkmal der vorliegenden Erfindung, daß über die Positionserfassung mittels magnetischer Positionssensoren die Erfassung der Position wenigstens eines Rastelementes zur Arretierung von signifikanten, den verschiedenen Gangstufen eines Fahrzeuggetriebes entsprechenden Zustands-Positionen eines Wählmechanismus auf einer Arretierungsmulden unterschiedlicher Tiefe aufweisenden Scheibe erfolgt. Es wird dabei durch die Auswertung der Eintauchtiefe des Rastelementes die jeweilige Stellung dieses Rastelementes auf der Scheibe ermittelt.

Die Aufgabe wird bzgl. der Vorrichtung dadurch gelöst, daß zur Kompensation des Einflusses von Fremdmagnetfeldern an den Sensorelementen eine Einrichtung zur aktiven Kompensation der Fremdmagnetfelder ausgebildet ist, die im wesentlichen ein weiteres, die Fremdmagnetfelder in einer separaten Messung erfassendes, Sensorelement umfaßt. Auf diese Weise wird erstmalig mit einfachen Mitteln die Möglichkeit geschaffen, den Einfluß von Fremdmagnetfeldern an den Sensorelementen weitgehend zu kompensieren sowie auch den Einfluß von Temperaturschwankungen in diesem Bereich, und zwar auf einfach und kostengünstig herstellbare Weise, es ist dabei die erfindungsgemäße Vorrichtung zur Positionsmessung auch gut in der Handhabung. Es wird dazu über das wenigstens eine weitere, die Fremdmagnetfelder in einer separaten Messung erfassende, Sensorelement die von äußeren Einflüssen angeregte Störgröße erfaßt, im Anschluß daran kann das Signal für die Meßposition über eine Recheneinheit korrigiert werden.

Bevorzugt umfaßt dabei nach einem weiteren Ausgestaltungsmerkmal der vorliegenden Erfindung die Einrichtung zur aktiven Kompensation der Fremdmagnetfelder im wesentlichen ein weiteres, die Fremdmagnetfelder in einer separaten Messung erfassendes, auf dem Hallprinzip basierendes Sensorelement, diese Ausführung ist insb. aus Kostengründen in diesem Anwendungsgebiet von besonderem Interesse. Es empfiehlt sich dabei, daß die Einrichtung zur Auswertung der Eintauchtiefe auf dem Hallprinzip basierende, die Position des in einer Richtung verschiebbaren, mit der zur erfassenden Position gekoppelten Magneten erfassende, Sensorelemente umfaßt.

Nach einem weiteren Merkmal der vorliegenden Erfindung ist die Einrichtung zur aktiven Kompensation der Fremdmagnetfelder mit dem wenigstens einen weiteren, die Fremdmagnetfelder in einer separaten Messung erfassenden Sensorelement derart ausgebildet, daß die durch die äußeren Einflüsse verursachten magnetischen Felder die Sensorelemente für die Positionsbestimmung und das Sensorelement für die separate Messung der Fremdmagnetfelder in gleicher Weise beeinflussen. Der Berechnungsfaktor für die Recheneinheit ist dabei besonders vorteilhaft, weiterhin ist eine optimale Temperaturkompensation gegeben.

Es empfiehlt sich nach einem weiteren Merkmal der vorliegenden Erfindung, daß die Einrichtung zur Auswertung der Eintauchtiefe des Rastelementes mit den Sensorelementen für die Positionsbestimmung derart ausgebildet ist, daß sich durch die Gestaltung der Geometrie des Magnetkreises eine Intensität des Magnetfeldes in der erfaßten Richtung ergibt, die ein zur Position des verschiebbaren Magneten proportionales Signal liefert.

Zweckmäßig ist es nach einem weiteren Merkmal der vorliegenden Erfindung, daß die Sensorelemente für die Messung der magnetischen Felder für die Positionsbestimmung und das Sensorelement für die separate Messung der Fremdmagnetfelder in geringer räumlicher Entfernung angeordnet sind. Dabei empfiehlt es sich, daß die Sensorelemente für die Messung der magnetischen Felder für die Positionsbestimmung und das Sensorelement für die separate Messung der Fremdmagnetfelder in einem Material mit thermisch hoher Leitfähigkeit eingebettet ausgebildet sind. Es ergibt sich dabei für die Sensorelemente für beide Messungen praktisch nahezu der gleiche Temperaturfehler.

Nach einem weiteren Merkmal der vorliegenden Erfindung ist vorgesehen, daß das Positionsmeßsystem mittels magnetischer Positionssensoren zur Erfassung der Position wenigstens eines Rastelementes zur Arretierung von signifikanten, den verschiedenen Gangstufen eines Fahrzeuggetriebes entsprechenden Zustands-Positionen eines Wählmechanismus auf einer Arretierungsmulden unterschiedlicher Tiefe aufweisenden Scheibe ausgebildet ist. Dabei wird durch die Auswertung der Eintauchtiefe des Rastelementes die jeweilige Stellung dieses Rastelementes auf der Scheibe ermittelt.

Nach einem letzten Merkmal der vorliegenden Erfindung ist vorgesehen, daß zur Minimierung der Beeinflussung des Sensorelementes für die separate Messung der Fremdmagnetfelder durch den verschiebbaren Magneten im Bereich dieses Sensorelementes eine Abschirmung insb. aus einem Material mit einer hohen magnetischen Leitfähigkeit angeordnet ist. Durch diese konstruktive Maßnahme wird die Beeinflussung des Sensorelementes für die separate Messung der Fremdmagnetfelder durch den verschiebbaren Magneten minimiert, wobei dem magnetischen Fluß durch die Abschirmung aus einem Material mit einer hohen magnetischen Leitfähigkeit ein bestimmter Weg vorgegeben wird. Der Verlauf der magnetischen Feldlinien wird also weitgehend durch die Abschirmung vorgegeben, so daß der Einfluß des Magneten auf ein Minimum reduziert wird.

Die Erfindung ist in den Figuren der Zeichnung in mehreren Ausführungsbeispielen dargestellt. Es zeigen:

Fig. 1    eine schematische, stark vereinfachte Darstellung des prinzipiellen Aufbaus ersten Ausführungsform des erfindungsgemäßen Positonsmeßsystemes ohne Vorliegen eines Fremdmagnetfeldes mit schematisch angedeuteten Anzeigeeinrichtungen für die Sensorelemente und Recheneinheit,

Fig. 2    die schematische, stark vereinfachte Darstellung des prinzipiellen Aufbaus der ersten Ausführungsform der erfindungsgemäßen Vorrichtung gemäß Fig. 1 mit Vorliegen eines Fremdmagnetfeldes, wieder mit schematisch angedeuteten Anzeigeeinrichtungen für die Sensorelemente und Recheneinheit,

Fig. 3    die schematische Darstellung der Ausführungsform der erfindungsgemäßen Vorrichtung gemäß Fig. 1 in drei unterschiedlichen Positionen des verschiebbaren Magneten mit detailliert angedeutetem Verlauf der Feldlinien des Fremdmagnetfeldes,

Fig. 4     die schematische Darstellung einer gegenüber Fig. 3 abgewandelten Ausführungsform der erfindungsgemäßen Vorrichtung mit Abschirmelement in drei unterschiedlichen Positionen des verschiebbaren Magneten mit detailliert angedeutetem Verlauf der Feldlinien des Fremdmagnetfeldes.

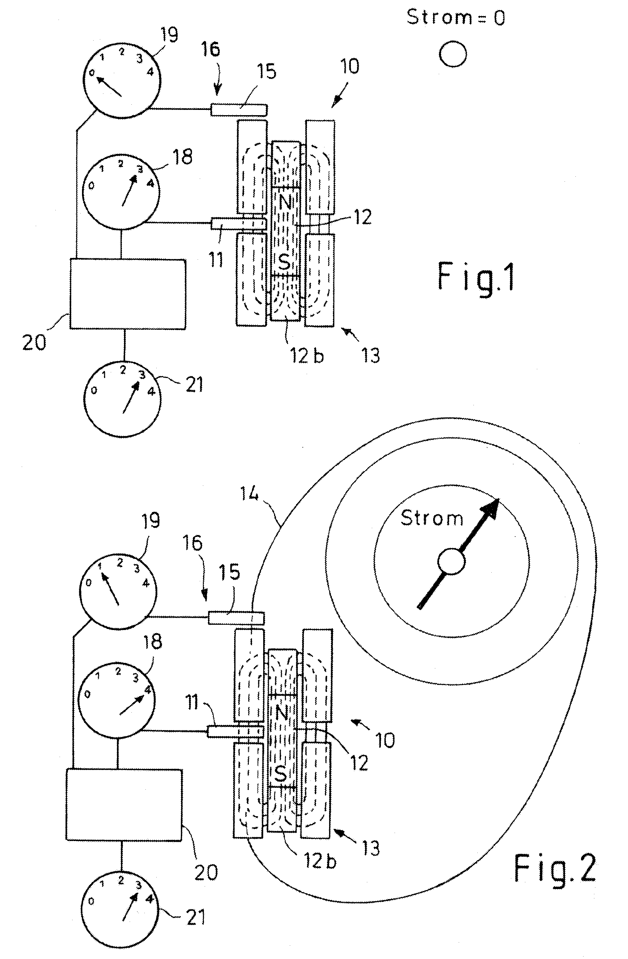

Das Positionsmeßsystem für das erfindungsgemäße Verfahren zur Positionserfassung mittels magnetischer Positionssensoren ist generell mit 10 bezeichnet. Das erfindungsgemäße Verfahren kann dabei beispielsweise zur Erfassung der Position wenigstens eines mit 13 bezeichneten Rastelementes zur Arretierung von signifikanten, den verschiedenen Gangstufen eines Fahrzeuggetriebes entsprechenden Zustands-Positionen eines Wählmechanismus auf einer Arretierungsmulden unterschiedlicher Tiefe aufweisenden Scheibe dienen, bei dem durch eine Auswertung der Eintauchtiefe z.B. dieses Rastelementes 13 die jeweilige Stellung dieses Rastelementes 13 auf der Scheibe ermittelt wird. Ein solches Rastelement 13 des erfindungsgemäßen Positionsmeßsystemes 10 ist in den Fig. 1 bis 4 der Zeichnung in unterschiedlichen Ausführungsformen schematisch in stark vereinfachter Weise dargestellt. Die Auswertung der Eintauchtiefe erfolgt dabei unter Verwendung von in diesem Falle auf dem Hallprinzip basierenden, mit 11 bezeichneten Sensorelementen, wobei diese Sensorelemente 11 die Position eines in einer Richtung verschiebbaren, mit der zu erfassenden Position gekoppelten Magneten 12 erfassen. Es greift dabei der mit der zur erfassenden Position gekoppelte verschiebbare Magnet 12 in den Magnetkreis ein und beeinflußt die Feldstärke an den die Position des Magneten 12 erfassenden Sensorelementen 11 in geeigneter Weise. Weiterhin wird der Einfluß von mit 14 bezeichneten Fremdmagnetfeldern an den Sensorelementen 11 in noch zu erläuternder Weise weitestgehend kompensiert.

Entsprechend ist das erfindungsgemäße Positionsmeßsystem 10 in diesem Falle zur Erfassung der Position wenigstens eines Rastelementes 13 zur Arretierung von signifikanten, den verschiedenen Gangstufen eines Fahrzeuggetriebes entsprechenden Zustands- Positionen eines Wählmechanismus auf einer Arretierungsmulden unterschiedlicher Tiefe aufweisenden Scheibe versehen mit einer Einrichtung zur Auswertung der Eintauchtiefe z.B. des Rastelementes 13 zur Ermittlung der jeweiligen Stellung dieses Rastelementes 13 auf der Scheibe, dabei umfaßt die Einrichtung zur Auswertung der Eintauchtiefe des Rastelementes 13 in diesem Falle auf dem Hallprinzip basierende Sensorelemente 11. Diese Sensorelemente 11 erfassen dabei die Position eines in einer Richtung verschiebbaren, mit der zur erfassenden Position gekoppelten Magneten 12. Der mit der zur erfassenden Position gekoppelte verschiebbare Magnet 12 ist derart angeordnet, daß dieser Magnet 12 in den Magnetkreis eingreift und die Feldstärke an den die Position des Magneten 12 erfassenden Sensorelementen 11 geeignet beeinflußt. Das erfindungsgemäße Positionsmeßsystem 10 ist im weiteren mit Mitteln zur weitestgehenden Kompensation des Einflusses von Fremdmagnetfeldern 14 an den Sensorelementen 11 versehen.

Gemäß dem erfindungsgemäßen Verfahren ist vorgesehen, daß die Kompensation des Einflusses von Fremdmagnetfeldern 14 an den hier auf dem Hallprinzip basierenden Sensorelementen 11 durch eine aktive Kompensation der Fremdmagnetfelder 14 über eine Verwendung wenigstens eines weiteren, die Fremdmagnetfelder 14 in einer separaten Messung erfassenden, Sensorelementes 15 erfolgt, dieses Sensorelement 15 ist beispielsweise aus den Fig. 1 und 2 der Zeichnung zu ersehen. Mit dem derart ausgebildeten Verfahren wird erstmalig mit einfachen Mitteln die Möglichkeit geschaffen, den Einfluß von Fremdmagnetfeldern 14 an den Sensorelementen 11 weitgehend zu kompensieren sowie auch der Einfluß von Temperaturschwankungen in diesem Bereich, und zwar auf einfach durchführbare Weise. Dabei umfaßt das erfindungsgemäße Verfahren einen Lösungsansatz, bei dem die Störfelder aktiv kompensiert werden. Es wird dazu über das wenigstens eine weitere, die Fremdmagnetfelder 14 in einer separaten Messung erfassende, Sensorelement 11 die von äußeren Einflüssen angeregte Störgröße erfaßt, im Anschluß daran wird dann über eine mit 20 bezeichnete Recheneinheit das Signal der Meßposition für die Eintauchtiefe (Sensorelement 11) mit Hilfe der Information über die Störgröße (Sensorelement 15) korrigiert. Die Aufgabe der Recheneinheit lautet dabei im vorliegenden Ausführungsbeispiel:

Ausgangsgröße = Sensor 11 - Faktor x Sensor 15,

diese Aufgabe der Recheneinheit kann mit einfachsten Rechenschaltungen durchgeführt werden.

Entsprechend ist gemäß dem erfindungsgemäßen Positionsmeßsstem 10 vorgesehen, daß zur Kompensation des Einflusses von Fremdmagnetfeldern 14 an den hier auf dem Hallprinzip basierenden Sensorelementen 11 eine Einrichtung 16 zur aktiven Kompensation der Fremdmagnetfelder 14 ausgebildet ist, die im wesentlichen ein weiteres, die Fremdmagnetfelder 14 in einer separaten Messung erfassendes, Sensorelement 15 umfaßt. Durch diese Ausbildung wird erstmalig mit einfachen Mitteln die Möglichkeit geschaffen, den Einfluß von Fremdmagnetfeldern 14 an den Sensorelementen 11 weitgehend zu kompensieren sowie auch den Einfluß von Temperaturschwankungen in diesem Bereich, und zwar auf einfach und kostengünstig herstellbare Weise, es ist dabei das erfindungsgemäße Positionsmeßsystem 10 auch gut in der Handhabung. Es wird dazu über das wenigstens eine weitere, die Fremdmagnetfelder 14 in einer separaten Messung erfassende, Sensorelement 11 die von äußeren Einflüssen angeregte Störgröße erfaßt, im Anschluß daran wird wie beschrieben das Signal für die Meßposition über eine Recheneinheit 20 korrigiert. Mit der erfindungsgemäßen Vorrichtung ist also auch eine weitgehende Kompensation des Einflusses von Temperaturschwankungen realisiert, was sich insb. bei einem Funktionsbereich der Sensorelemente 11,15 in der kritischen Position sehr deutlich auswirkt, und zwar auch bereits bei der Ausführungsform ohne zusätzliche Abschirmung 17.

Bei dem erfindungsgemäßen Verfahren ist vorgesehen, daß die aktive Kompensation der Fremdmagnetfelder 14 über eine Verwendung wenigstens eines weiteren, die Fremdmagnetfelder 14 in einer separaten Messung erfassenden, auf dem Hallprinzip basierenden Sensorelementes 15 erfolgt, entsprechend ist gemäß der erfindungsgemäßen Vorrichtung vorgesehen, daß die Einrichtung 16 zur aktiven Kompensation der Fremdmagnetfelder 14 im wesentlichen ein weiteres, die Fremdmagnetfelder 14 in einer separaten Messung erfassendes, auf dem Hallprinzip basierendes Sensorelement 15 umfaßt. Diese Ausbildung des erfindungsgemäßen Verfahrens bzw. der erfindungsgemäßen Vorrichtung ist insb. aus Kostengründen in diesem Anwendungsgebiet vorteilhaft.

Die aktive Kompensation der Fremdmagnetfelder 14 über das weitere die Fremdmagnetfelder 14 in einer separaten Messung erfassenden Sensorelement 15 erfolgt bei der dargestellten Ausführungsform in der Weise, daß die durch die äußeren Einflüsse verursachten magnetischen Felder die Sensorelemente 11 für die Positionsbestimmung und das Sensorelement 15 für die separate Messung der Fremdmagnetfelder 14 in gleicher Weise beeinflussen. Entsprechend ist vorliegend die Einrichtung 16 zur aktiven Kompensation der Fremdmagnetfelder 14 mit dem wenigstens einen weiteren, die Fremdmagnetfelder 14 in einer separaten Messung erfassenden Sensorelement 15 derart ausgebildet, daß die durch die äußeren Einflüsse verursachten magnetischen Felder die Sensorelemente 11 für die Positionsbestimmung und das Sensorelement 15 für die separate Messung der Fremdmagnetfelder 14 in gleicher Weise beeinflussen. In diesem Fall ist der Berechnungsfaktor für die von der Recheneinheit 20 zu ermittelnde Ausgangsgröße besonders vorteilhaft, d.h. dieser Berechnungsfaktor ist im idealen Falle gleich 1, weiterhin es ist eine optimale Temperaturkompensation gegeben.

Die Erfassung des Magnetfeldes über die Sensorelemente 11 für die Positionsbestimmung erfolgt bei dem dargestellten Ausführungsbeispiel in der Weise, daß sich durch die Gestaltung der Geometrie des Magnetfeldes eine Intensität des Magnetkreises in der erfaßten Richtung ergibt, die ein zur Position des verschiebbaren Magneten 12 proportionales Signal liefert, entsprechend ist die Einrichtung zur Auswertung der Eintauchtiefe hier des Rastelementes 13 mit den Sensorelementen 11 für die Positionsbestimmung derart ausgebildet, daß sich durch die Gestaltung der Geometrie des Magnetkreises eine Intensität des Magnetfeldes in der erfaßten Richtung ergibt, die ein zur Position des verschiebbaren Magneten 12 proportionales Signal liefert. Es wird bzgl. dieser Ausbildung beispielsweise auf die Fig. 1 der Zeichnung verwiesen. Der Magnet 12 des Rastelementes 13 ist in seiner Position abhängig von der zu erfassenden Meßgröße. Aufgrund der vertikalen Verschiebung des Magneten 12 ändert sich der Vektor des Magnetfeldes (Intensität und Richtung) an der Position des Sensorelementes 11. Die Intensität des Magnetfeldes in Y-Richtung wird vom Sensorelement 11 erfaßt und ergibt in diesem Falle ein zur Position des verschiebbaren Magneten 12 proportionales Signal.

Da die Signalverfälschung aufgrund des Temperatureinflusses sowie auch die äußeren magnetischen Einflüsse beide Sensorelemente 11 und 15 betreffen, erfolgt die Messung der magnetischen Felder für die Positionsbestimmung und die separate Messung der Fremdmagnetfelder 14 vorliegend in geringer räumlicher Entfernung und über in einem Material mit thermisch hoher Leitfähigkeit eingebettete Sensorelemente 11,15. Entsprechend sind vorliegend die Sensorelemente 11 für die Messung der magnetischen Felder für die Positionsbestimmung und das Sensorelement 15 für die separate Messung der Fremdmagnetfelder 14 in geringer räumlicher Entfernung angeordnet und in einem Material mit thermisch hoher Leitfähigkeit eingebettet ausgebildet. Es ergibt sich dadurch für beide Messungen praktisch nahezu der gleiche Temperaturfehler. Wenn in diesem Falle nur der Temperaturfehler vorliegt, kann dieser mit einer einfachen Subtraktion der Sensorausgangssignale kompensiert werden:

$$\text{Ausgangsgröße} = \text{Sensor } 11 - \text{Sensor } 15.$$

Bezüglich der aktiven Kompensation der Fremdmagnetfelder 14 sei noch einmal auf die Darstellung gemäß den Fig. 1 und 2 der Zeichnung verwiesen. Fig. 1 zeigt ein Rastelement 13 ohne Vorliegen eines Fremdmagnetfeldes 14 und Fig. 2 zeigt ein Rastelement 13 mit Vorliegen eines Fremdmagnetfeldes 14, wobei in beiden Figuren schematisch eine Anzeige 18 für das Sensorelement 11, eine Anzeige 19 für das Sensorelement 15, eine Recheneinheit 20 und eine Ergebnisanzeige 21 dargestellt sind. Mit den Darstellungen gemäß den Fig. 1 und 2 soll insb. folgendes veranschaulicht werden:

Durch Fremdeinflüsse wird dem Magnetfeld, das der Position des Magneten 12 entspricht, ein weiteres Magnetfeld überlagert. Das Sensorelement 11 kann eine Unterscheidung des Magnetfeldes, hervorgerufen durch den Magneten 12 oder durch die Fremdeinflüsse, nicht vornehmen. Aus diesem Grund ist ein weiteres Sensorelement 15 angeordnet, das zur Messung der Störung angebracht ist. Die Störung wird gemessen und mit geeigneter Skalierung vom Meßsignal abgezogen. Fig. 1 zeigt dazu für die Position des Magneten 12 die dimensionslose Anzeige von 3 an und es liegt keine Störung vor. Dieser Wert an der Anzeige 19 ist also 0, somit ergibt sich als Ergebnis auf der Ergebnisanzeige 21 der Wert 3. In Fig. 2 liegt ein Fremdmagnetfeld 14 vor, der gemessene Störpegel auf der Anzeige 19 ist hierbei 1, bei bevorzugter Anordnung beider Sensorelemente 11,15 liegt für die gleiche Position des Magneten 12 für die Meßposition an der Anzeige 18 der dimensionslose Wert 4 vor. Der aufbereitete Wert, in diesem Fall Sensorelement 11 - Sensorelement 15, ist somit auf der Ergebnisanzeige 21 wieder die 3. Die Störung wird also aktiv durch separate Messung der Störpegel kompensiert.

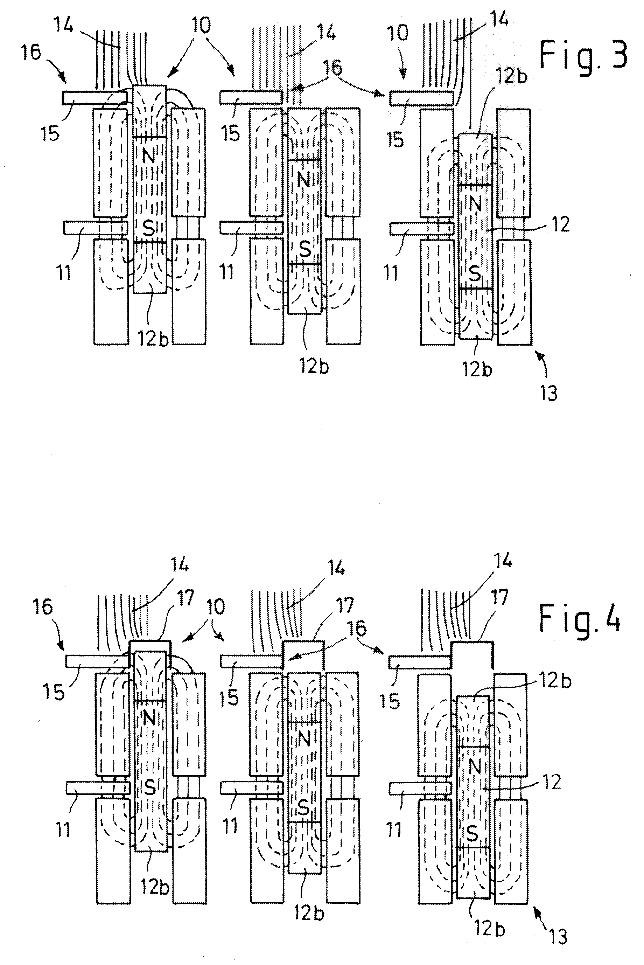

Zur Minimierung der Beeinflussung des Sensorelementes 15 für die separate Messung der Fremdmagnetfelder 14 durch den über einen Magnetträger 12b verschiebbaren Magneten 12 ist im Bereich dieses Sensorelementes 15, siehe dazu die Darstellung gemäß der Fig. 4 der Zeichnung, eine Abschirmung 17 insb. aus einem Material mit einer hohen magnetischen Leitfähigkeit angeordnet. Die Fig. 3 und 4 zeigen dazu beispielhaft den prinzipiellen Verlauf der magnetischen Feldlinien, die durch äußere Einflüsse entstehen und den Verlauf derer in Abhängigkeit von der Position des Magnetträgers 12b. Es ist dazu dieser Magnetträger 12b in den Fig. 3 und 4 jeweils in drei unterschiedlichen Positionen dargestellt. Auffällig in der Fig. 3 ist, das der Einfluß der Störung an der eingezeichneten Position für das Sensorelement 15 abhängig von der Position des Magnetträgers 12b ist. So werden in der linken Position in Fig.3 die Feldlinien zum Magnetträger 12b abgelenkt, weil dies der leichtere Weg ist, während in der rechten Position in Fig.3 diese Feldlinien zum äußeren Ring hin abgelenkt werden, weil der Magnetträger 12b in diesem Falle weiter entfernt ist. In der Position des Sensorelementes 11 wird dagegen der Verlauf dieser Feldlinien nur unwesentlich beeinflußt durch die Position des Magnetträgers 12b. Aufgabe ist es daher, eine Position für das Sensorelement 15 zu definieren, die zum einen betragsmäßig die gleiche Störung erfährt und zum anderen die Feldlinien der Störungen nicht durch die Position des Magnetträgers 12b beeinflußt werden. Dies wird durch die konstruktive Maßnahme der Abschirmung 17 im Bereich des Sensorelementes 15 erreicht, wie es in der Fig. 4 dargestellt ist. Diese Abschirmung 17 besteht aus einem magnetisch sehr gut leitfähigen Material, so daß der Einfluß des Magneten 12 zum Sensorelement 15 abgeschirmt wird. Im Bereich dieser Abschirmung 17 kann also eine Position definiert werden, welche die gleichen magnetischen Störungen erfährt wie Sensorelement 11. Die Abschirmung 17 gibt dabei immer den gleichen Weg für die Feldlinien vor, weil durch diese Abschirmung 17 unabhängig von der Position des Magnetträgers 12b der leichteste Weg vorgegeben wird.

Bei den Darstellungen gemäß den Fig. 3 und 4 geht es also um den detaillierteren Verlauf der Feldlinien der Störung und der Beeinflussung dieser Feldlinien durch die Position des Magnetträgers 12b. Der Verlauf der Feldlinien wird durch die bessere magnetische Leitfähigkeit des Magneten 12 im unmittelbaren Umfeld der oberen Öffnung stark beeinflußt. Bei gleich starker Störungsaufschaltung variiert der Meßwert an der Position des Sensorelementes 15 mit der Position des Magnetträgers 12b (s. Fig.3). Die Beeinflussung der Position des Sensorlementes 11 ist dagegen sehr gering. Damit ergibt sich ein prinzipieller Fehler bei der Kompensation des Meßwertes. Um eine Beeinflussung des Sensorlementes 15 zu minimieren, wird also durch konstruktive Maßnahmen dem magnetischen Fluß ein Weg vorgegeben, wie in Fig. 4 mit einer Abschirmung 17 aus einem Material mit einer hohen magnetischen Leitfähigkeit. Der Verlauf der magnetischen Feldlinien wird nun weitgehend durch die Abschirmung 17 vorgegeben, so daß der Einfluß des Magneten 12 auf ein Minimum reduziert wird.

Wie bereits erwähnt, sind die dargestellten Ausführungsformen nur beispielsweise Verwirklichungen der Erfindung, diese ist nicht darauf beschränkt, es sind vielmehr noch mancherlei Abänderungen und Ausbildungen möglich. So können insb. die Sensorelemente 11 für die Messung der magnetischen Felder für die Positionsbestimmung und das Sensorelement 15 für die separate Messung der Fremdmagnetfelder 14 eine von den dargestellten Ausführungsformen abweichende Ausbildung und Anordnung aufweisen, möglich wäre z. B. auch eine Verwendung von GMR- Sensorelementen oder GMX- Sensorelementen. Weiterhin denkbar ist eine abweichende Anordnung des Magneten 12 in dem Positionsmeßsystem 10 sowie abweichende Ausbildungen der Recheneinheit 20 und der Anzeigeelemente.

## Patentansprüche

1. Verfahren zur Positionserfassung mittels magnetischer Positionssensoren, bei dem durch eine Auswertung der Eintauchtiefen die Position ermittelt wird, wobei die Auswertung der Eintauchtiefe unter Verwendung von die Position eines in einer Richtung verschiebbaren, mit der zu erfassenden Position gekoppelten Magneten (12) erfassenden, Sensorelementen (11) erfolgt, wobei der mit der zur erfassenden Position gekoppelte verschiebbare Magnet (12) in den Magnetkreis eingreift und die Feldstärke an den die Position des Magneten (12) erfassenden Sensorelementen (11) geeignet beeinflußt und wobei der Einfluß von Fremdmagnetfeldern (14) an den Sensorelementen (11) weitestgehend kompensiert wird,
**dadurch gekennzeichnet, daß**
die Kompensation des Einflusses von Fremdmagnetfeldern (14) an den Sensorelementen (11) durch eine aktive Kompensation der Fremdmagnetfelder (14) über eine Verwendung wenigstens eines weiteren, die Fremdmagnetfelder (14) in einer separaten Messung erfassenden, Sensorelementes (15) erfolgt.

2. Verfahren nach Anspruch 1,
**dadurch gekennzeichnet, daß**
die aktive Kompensation der Fremdmagnetfelder (14) über eine Verwendung wenigstens eines weiteren, die Fremdmagnetfelder (14) in einer separaten Messung erfassenden, auf dem Hallprinzip basierenden Sensorelementes (15) erfolgt.

3. Verfahren nach Anspruch 1 oder 2,
**dadurch gekennzeichnet, daß**
die Auswertung der Eintauchtiefe unter Verwendung von auf dem Hallprinzip basierenden, die Position des in einer Richtung verschiebbaren, mit der zu erfassenden Position gekoppelten Magneten (12) erfassenden, Sensorelementen (11) erfolgt.

4. Verfahren nach einem der Ansprüche 1 bis 3,
**dadurch gekennzeichnet, daß**
die aktive Kompensation der Fremdmagnetfelder (14) über das weitere die Fremdmagnetfelder (14) in einer separaten Messung erfassenden Sensorelement (15) in der Weise erfolgt, daß die durch die äußeren Einflüsse verursachten magnetischen Felder die Sensorelemente (11) für die Positionsbestimmung und das Sensorelement (15) für die separate Messung der Fremdmagnetfelder (14) in gleicher Weise beeinflussen.

5. Verfahren nach einem der Ansprüche 1 bis 4,
**dadurch gekennzeichnet, daß**
die Erfassung des Magnetfeldes über die Sensorelemente (11) für die Positionsbestimmung in der Weise erfolgt, daß sich durch die Gestaltung der Geometrie des Magnetfeldes eine Intensität des Magnetkreises in der erfaßten Richtung ergibt, die ein zur Position des verschiebbaren Magneten (12) proportionales Signal liefert.

6. Verfahren nach einem der Ansprüche 1 bis 5,
**dadurch gekennzeichnet, daß**
die Messung der magnetischen Felder für die Positionsbestimmung und die separate Messung der Fremdmagnetfelder (14) in geringer räumlicher Entfernung erfolgt.

7. Verfahren nach Anspruch 6,
**dadurch gekennzeichnet, daß**
die Messung der magnetischen Felder für die Positionsbestimmung und die separate Messung der Fremdmagnetfelder (14) über in einem Material mit thermisch hoher Leitfähigkeit eingebettete Sensorelemente (11,15) erfolgt.

8. Verfahren nach einem der Ansprüche 1 bis 7,
**dadurch gekennzeichnet, daß**
über die Positionserfassung mittels magnetischer Positionssensoren die Erfassung der Position wenigstens eines Rastelementes (13) zur Arretierung von signifikanten, den verschiedenen Gangstufen eines Fahrzeuggetriebes entsprechenden Zustands- Positionen eines Wählmechanismus auf einer Arretierungsmulden unterschiedlicher Tiefe aufweisenden Scheibe erfolgt.

9. Positionsmeßsystem mittels magnetischer Positionssensoren, mit einer Einrichtung zur Auswertung der Eintauchtiefe zur Ermittlung der jeweiligen Position, wobei die Einrichtung zur Auswertung der Eintauchtiefe die Position eines in einer Richtung verschiebbaren, mit der zur erfassenden Position gekoppelten Magneten (12) erfassende, Sensorelemente (11) umfaßt, wobei der mit der zur erfassenden Position gekoppelte verschiebbare Magnet (12) derart angeordnet ist, daß dieser Magnet (12) in den Magnetkreis eingreift und die Feldstärke an den die Position des Magneten (12) erfassenden Sensorelementen (11) geeignet beeinflußt, und mit Mitteln zur weitestgehenden Kompensation des Einflusses von Fremdmagnetfeldern (14) an den Sensorelementen (11),
**dadurch gekennzeichnet, daß**
zur Kompensation des Einflusses von Fremdmagnetfeldern (14) an den Sensorelementen (11) eine Einrichtung (16) zur aktiven Kompensation der Fremdmagnetfelder (14) ausgebildet ist, die im wesentlichen ein weiteres, die Fremdmagnetfelder (14) in einer separaten Messung erfassendes, Sensorelement (15) umfaßt.

10. Vorrichtung nach Anspruch 9,
**dadurch gekennzeichnet, daß**
die Einrichtung (16) zur aktiven Kompensation der Fremdmagnetfelder (14) im wesentlichen ein weiteres, die Fremdmagnetfelder (14) in einer separaten Messung erfassendes, auf dem Hallprinzip basierendes Sensorelement (15) umfaßt.

11. Vorrichtung nach Anspruch 9 oder 10,
**dadurch gekennzeichnet, daß**
die Einrichtung (16) zur Auswertung der Eintauchtiefe auf dem Hallprinzip basierende, die Position des in einer Richtung verschiebbaren, mit der zur erfassenden Position gekoppelten Magneten (12) erfassende, Sensorelemente (11) umfaßt.

12. Vorrichtung nach einem der Ansprüche 9 bis 11,
**dadurch gekennzeichnet, daß**
die Einrichtung (16) zur aktiven Kompensation der Fremdmagnetfelder (14) mit dem wenigstens einen weiteren, die Fremdmagnetfelder (14) in einer separaten Messung erfassenden Sensorelement (15) derart ausgebildet ist, daß die durch die äußeren Einflüsse verursachten magnetischen Felder die Sensorelemente (11) für die Positionsbestimmung und das Sensorelement (15) für die separate Messung der Fremdmagnetfelder (14) in gleicher Weise beeinflussen.

13. Vorrichtung nach einem der Ansprüche 9 bis 12, **dadurch gekennzeichnet, daß** die Einrichtung zur Auswertung der Eintauchtiefe des Rastelementes (10) mit den Sensorelementen (11) für die Positionsbestimmung derart ausgebildet ist, daß sich durch die Gestaltung der Geometrie des Magnetkreises eine Intensität des Magnetfeldes in der erfaßten Richtung ergibt, die ein zur Position des verschiebbaren Magneten (12) proportionales Signal liefert.

14. Vorrichtung nach einem der Ansprüche 9 bis 13, **dadurch gekennzeichnet, daß** die Sensorelemente (11) für die Messung der magnetischen Felder für die Positionsbestimmung und das Sensorelement (15) für die separate Messung der Fremdmagnetfelder (14) in geringer räumlicher Entfernung angeordnet sind.

15. Vorrichtung nach Anspruch 14, **dadurch gekennzeichnet, daß** die Sensorelemente (11) für die Messung der magnetischen Felder für die Positionsbestimmung und das Sensorelement (15) für die separate Messung der Fremdmagnetfelder (14) in einem Material mit thermisch hoher Leitfähigkeit eingebettet ausgebildet sind.

16. Vorrichtung nach einem der Ansprüche 1 bis 15, **dadurch gekennzeichnet, daß** das Positionsmeßsystem (10) mittels magnetischer Positionssensoren zur Erfassung der Position wenigstens eines Rastelementes (13) zur Arretierung von signifikanten, den verschiedenen Gangstufen eines Fahrzeuggetriebes entsprechenden Zustands- Positionen eines Wählmechanismus auf einer Arretierungsmulden unterschiedlicher Tiefe aufweisenden Scheibe ausgebildet ist.

17. Vorrichtung nach einem der Ansprüche 9 bis 16, **dadurch gekennzeichnet, daß** zur Minimierung der Beeinflussung des Sensorelementes (15) für die separate Messung der Fremdmagnetfelder (14) durch den verschiebbaren Magneten (12) im Bereich dieses Sensorelementes (15) eine Abschirmung (17) insb. aus einem Material mit einer hohen magnetischen Leitfähigkeit angeordnet ist.

Strom = 0

19
16
15
10

N

S

12

11

12 b    13

20

21

Fig.1

14
Strom

19
16
15

N

S

12

11    10

18

20    12 b    13

21

Fig.2

Fig. 3

Fig. 4

**Europäisches Patentamt**

## EUROPÄISCHER RECHERCHENBERICHT

Nummer der Anmeldung

EP 03 10 2381

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| Y | FR 2 809 808 A (MOVING MAGNET TECHNOLOGIES) 7. Dezember 2001 (2001-12-07) * Seite 1, Zeile 4 - Zeile 6 * * Seite 2, Zeile 28 - Seite 3, Zeile 31 * * Seite 4, Zeile 11 - Zeile 17 * * Seite 5, Zeile 17 - Zeile 25 * * Seite 9, Zeile 1 - Zeile 18; Abbildung 5 * --- | 1-17 | G01D5/14 G01D3/036 |
| Y | US 4 943 772 A (MAUPU JEAN-LOUIS ET AL) 24. Juli 1990 (1990-07-24) * Spalte 3, Zeile 43 - Zeile 65 * * Spalte 4, Zeile 31 - Zeile 48 * ----- | 1-17 | |

RECHERCHIERTE SACHGEBIETE (Int.Cl.7)

G01D

Der vorliegende Recherchenbericht wurde für alle Patentansprüche erstellt

| Recherchenort | Abschlußdatum der Recherche | Prüfer |
|---|---|---|
| DEN HAAG | 15. Januar 2004 | Keita, M |

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 03 10 2381

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

15-01-2004

| Im Recherchenbericht angeführtes Patentdokument | Datum der Veröffentlichung | Mitglied(er) der Patentfamilie | Datum der Veröffentlichung |
|---|---|---|---|
| FR 2809808 A | 07-12-2001 | FR 2809808 A1<br>EP 1290403 A1<br>WO 0194875 A1 | 07-12-2001<br>12-03-2003<br>13-12-2001 |
| US 4943772 A | 24-07-1990 | FR 2630204 A1<br>AT 79175 T<br>CA 1317654 C<br>DE 68902347 D1<br>DE 68902347 T2<br>EP 0338381 A1<br>ES 2034459 T3 | 20-10-1989<br>15-08-1992<br>11-05-1993<br>10-09-1992<br>24-12-1992<br>25-10-1989<br>01-04-1993 |

EPO FORM P0461

Für nähere Einzelheiten zu diesem Anhang : siehe Amtsblatt des Europäischen Patentamts, Nr.12/82